# EUROPEAN PATENT APPLICATION

(11) **EP 2 015 356 A1**
(43) Date of publication of application: **14.01.2009**
(21) Application number: 07112461.4
(22) Date of filing: 13.07.2007
(51) Int. Cl.: H01L 21/78

(54) **Method for singulation of wafers**

(71) Applicant: PVA TePla AG, 35614 Asslar (DE)
(72) Inventor: Amberger, Martin, 81377 Munich (DE); Heinze, Peter-Matthias, Dr., 85567 Grafing (DE)
(74) Representative: Cullinane, Marietta Bettina

(57) **Abstract**

A method for singulating wafers is disclosed. The method comprises the steps of: introducing trenches (13) between dies (15) to be separated in the active side (11) of a thick wafer (1); applying a singulation tape (7) on the active side (11) of the wafer (1), wherein the singulation tape (7) is unsupported from the side facing away from the wafer (1) and separating the dies (15) by etching the wafer (1) on the unsupported singulation tape (7) from the backside (12) of the wafer (1).

## Description

The present invention relates to a method for singulation of wafers, in particular for singulating dies or chips from a wafer.

The need for thin and ultra thin dies, in particular silicon dies, is ever increasing. The handling of these thin and ultra thin silicon dies as well as the provisioning of required properties poses technical hurdles.

One process for singulating dies from a wafer is known as dicing before grinding (DBG). In this process, trenches or streets are provided in a first side of the wafer, in particular in the active side of the wafer, by dicing with a dicing blade or via laser technology. Subsequently, the wafer is thinned by grinding of the backside of the wafer, until the streets are opened and the dies are singulated. During the back grinding step, the wafer is held on a so called back grinding tape, which has to provide sufficient adhesion force to prevent the dies from being spun off or detached from the back grinding tape during the grinding step. In addition, the pressure applied to the individual dies increases with decreasing thickness of the wafer. This may lead to damaging of the dies and of the active elements and wiring provided on the dies.

In a different approach for singulating dies from a wafer, the wafer is first thinned to the desired thickness of the resulting dies. Subsequently, the individual dies are singulated by dicing with a dicing blade from the front side of the wafer, i.e. the active side of the wafer. The drawback of this process is mainly the danger of chipping of the dies at the front side of the wafer and the damaging of the active elements on the active side of the wafer.

Known thinning and singulation techniques comprise technologies wherein the dies are singulated by dicing via a laser or a dicing blade and so called scribe and break technologies. All these known technologies have the disadvantage that the application of a mechanical impact is necessary. This mechanical impact may result in the destruction of the crystal lattice structure of the silicon or other wafer material carrying the circuits. The destruction of the crystal lattice structure leads to a drastic increase in breakage probability. Also the mechanical force during a grinding process, in particular in the DBG process, leads to additional stress on fragile structures such as low k dielectrics. Furthermore, contamination can occur as particles, water and also metals are present during the singulation process, in particular in the singulation by dicing from the active side.

There have also been suggestions on dividing a wafer by etching the backside of a wafer with streets defined in its front or active side. This etching is carried out on a wafer substrate having a solid wafer substrate with an adhesive layer attached to it. The drawback of this process is that the picking of the finished dies or chips from the substrate has to be performed by temperature or light changes and the solid substrate has to be selected according to these requirements, leading to costly components for the process.

The problem to be solved by the present invention is thus to provide a solution for singulation of dies, which alleviates the above mentioned drawbacks and thus allows high production yields even in ultrathin wafer manufacturing as well as an easy and cost efficient handling of the wafer.

The invention is based on the finding that this problem can be solved by using a singulation method which only includes minimal mechanical processing of the wafer and only employs easy handling equipment.

According to the present invention, the problem is solved by a method for singulating wafers which comprises the steps of: introducing trenches between dies to be separated in the active side of a thick wafer; applying a singulation tape on the active side of the wafer, wherein the singulation tape is unsupported from the side facing away from the wafer and etching the backside of the wafer on the unsupported singulation tape thereby at least separating the dies on the wafer.

Singulating wafers according to the present invention is referred to as the provision of dies or chips from the wafer. The active side of the wafer is referred to as the side where active elements, such as transistors or integrated circuits are provided. Unsupported according to the present invention means that in the area of the dies no additional support or substrate is provided on the side of the tape opposite to the side which is adjacent to the wafer. In particular, the tape is free of a substrate attached to the tape, e.g. glued, at the opposite side to the side adjacent the wafer in the area of the dies.

One advantage of arranging the prepared wafer on a singulation tape which is unsupported is that the removal of the singulated dies from the singulation tape can easily be performed. The removal or picking of the dies may for example be performed by applying pressure on the backside of the singulation tape or by applying suction force on the side of the die facing away from the singulation tape. An alteration of the attachment force of glue on the singulation tape is not necessary. Hence, the variety of glues and tapes that can be used for the inventive process is large and also tapes which can be manufactured at low cost can be used. In addition, the unsupported tape also allows for a chuck on which the taped wafer may be placed during the etching step to have effect on the wafer. Hence, suction or a temperature influence from e.g. from a cooled chuck can be transmitted to the wafer and the dies, respectively.

The etching of the backside of the wafer according to the present invention at least leads to the singulation of the dies of the wafer. In addition, the etching will preferably provide so called stress relief on the backside of the wafer and the dies, respectively, as well as on the side walls of the dies after the singulation of the dies.

According to a preferred embodiment, the etching of the wafer from the backside is an etching step performed with a dry etching method which is based on radicals.

By using such an etching method a number of advantages can be achieved. First of all radical based etching method results in an isotropic etch profile. Hence, during the singulation of the dies and the subsequent etching treatment of the sidewalls, the side walls of the individual dies will be etched sufficiently to provide stress relief and subsequent passivation. This treatment of the sidewalls will not sufficiently be possible with other etching methods which provide anisotropic etch profiles. Due to the treatment of the sidewalls by radical based etching it is possible to provide the trenches in the front side of the wafer by methods which destroy the crystal lattice structure on the surface such as dicing or laser technology. The destructed crystal lattice structure will be removed during the singulation by etching. In addition, an advantage of a radical based etching method for singulating the dies, lies in the fact that the etching will be carried out at low temperatures and will also not lead to high temperatures at the wafer during the etching. Hence, the requirements for the material of the singulation tape and the glue of the singulation tape are reduced to a minimum. Also a warping of the wafer due to high temperatures which are present with other known dry etching methods does not occur with the inventive method.

Furthermore, the singulation of the dies can be performed without leaving residues in the gaps between the singulated dies. This is not possible with conventional wet chemical etching or mechanical singulating methods as water, metal and other residues will remain between the dies.

According to a preferred embodiment, the etching method is a plasma etching method, in particular a remote plasma etching method. The etching time can be adjusted by choosing the plasma density. Damages which may occur in an etching method based on ion impingement can be avoided and the treated surface will show improved properties.

The plasma source used for the inventive method is preferably a source capable of producing a high plasma density whereby the mere chemical etching of the surfaces can be assured. The plasma source may for example be the source described in WO 00/24031. The etching gas may be a reactive gas, which in general provides a high etching speed and has a high selectivity. The etching gas may for example be a fluorine containing gas such as SF₆.

The singulation tape preferably has a good thermal conductance and a low coefficient of thermal expansion (CTE). In addition, the glue layer of the singulation tape and thus the singulation tape itself has a low sticking capability. The adhesive strength of the glue layer is lower than the adhesive strength known for back grinding tapes. The adhesive strength may for example be lower then 300 g/25mm.

According to one embodiment, the thickness or height of the glue layer on the singulation tape is less then 10µm, preferably less then 5µm. Such a thin layer of glue is advantageous in that the picking of the singulated chips can be performed without necessitating a high force to overcome the adhesion force. Hence, damaging of the dies or chips can be avoided. In addition, the minimal amount of glue is advantageous in that the glue will not or only to a minimal amount enter into the streets or trenches on the active side of the wafer. The side walls of the dies are thus free of glue and can be treated by the etching during and/or after the singulation of the dies, in particular a stress relief of the side walls will become possible. Such treatment is not possible with dies, which are being held on a tape suitable for grinding. Such tapes require a larger thickness of the glue layer in order to keep the wafer and subsequently the dies in place during grinding. The glue will enter into the streets and will attach to the sidewalls. A treatment of the sidewalls will thus not be possible. In addition, the glue may also provide problems when picking individual dies, as these may be attached to each other via the glue. In such cases the release of the dies from the tape has to be performed by changing the properties of the glue, e.g. by UV exposure or temperature increase. This changing of the properties, however, require specific properties of the tape, where the glue is provided, e.g. UV permeability and/or temperature resistance. Such specific tape properties are not required with the inventive concept and in particular not with a singulation tape having a thin glue layer.

According to one embodiment, the singulation tape is attached to a frame.

By providing a frame to the tape, the handling of the wafer on the tape, e.g. during processing of the wafer as well as during shipping and storage can be facilitated. In addition, the frame can serve as a guide for securely and accurately placing the taped wafer on a chuck. Furthermore, the frame can serve as a protection of the wafer and the singulated dies. Finally, the attachment of the singulation tape on the wafer before the etching is facilitated by the frame. The frame, however, allows a high etch rate, as it maintains the tape and thus the wafer in a given position.

According to another embodiment of the invention, the process comprising the step of grinding the wafer from the backside before the etching step. By including a grinding step into the process the full wafer where the streets or trenches are being defined in can have a larger thickness. These wafers are easier to handle and cheaper to manufacture.

Preferably, the wafer is held on a tape different to the singulation tape during the grinding step. The tape used during the grinding step will hereinafter also be referred to as a back grinding tape. The re-taping of the wafer between the grinding and the singulating step has several advantages. First of all the back grinding tape can be chosen according to the requirements necessary during grinding. Hence, in particular a tape having a thick glue layer and/or a glue with a high adhesion force can be used. The shifting of the wafer during grinding can thereby be avoided. Also the singulation tape can be chosen according to the requirements of the singulating step. The re-taping of the wafer has the additional advantage that the wafer will be turned on its backside after the grinding step. Any particles or water that may have entered into the streets during the grinding step may hence fall or flow to the bottom of the streets or trenches. During the detaching of the back grinding tape which may be done by UV exposure, also the particles and water may be effected. The water may evaporate and the particles may adhere to the bottom of the streets, i.e. the bridges between the dies. Hence, once the singulation tape is attached to the active side of the wafer, this side is clean and no particles or water will contact the active elements or penetrate to the active elements during the subsequent etching step.

Preferably the de-taping of the wafer and the application of the singulation tape are being performed on one single chuck. This procedure has the advantage that the thinned wafer, which does not have any protection on the active side between the de-taping and application of the singulation tape does not have to be moved. With the inventive process the active side is always protected by a tape.

According to one embodiment, the streets or trenches are being introduced into the active side of the wafer by means of a dicing blade or by laser. These methods are advantageous in that the costs and maintenance for the processing machines are kept to a minimum. The usage of such methods is only possible as according to the present invention the destroyed crystal lattice structure on the side walls of the dies will be treated after the singulation of the dies by etching.

The trenches in the active side of the wafer may have a depth which corresponds to the or is smaller then the intended final height of the die. According to one embodiment, the streets or trenches which are provided in the active side of the wafer are deeper, i.e. have a larger depth, than the intended final height of the die. Thereby connections such as copper connections which may be provided at the backside of active elements on the active side of the wafer can be avoided during grinding of the backside of the wafer or polishing of the wafer. Only once the dies have been singulated, the etching of the backsides of the dies will lead to a selective etching of wafer material between such connections and will thus expose the connections.

The inventive method is thus applicable for singulating dies from a wafer, wherein the dies are chips with IC circuits, elements for 3-D-internconnect assemblies, SOI elements and other semiconductor elements.

As the present invention can easily be integrated into existing production lines developed for DBG processes and in addition also can be performed with reasonably priced material such as a singulation tape compared to a solid wafer support, it provides an economic solution for providing chips or dies with an increased quality, a high production yield due to low amount of damaged chips or dies and a low production time due to high etching rates.

The invention will now be described again with reference to the enclosed drawings, wherein:
- Figure 1: shows a wafer with trenches;

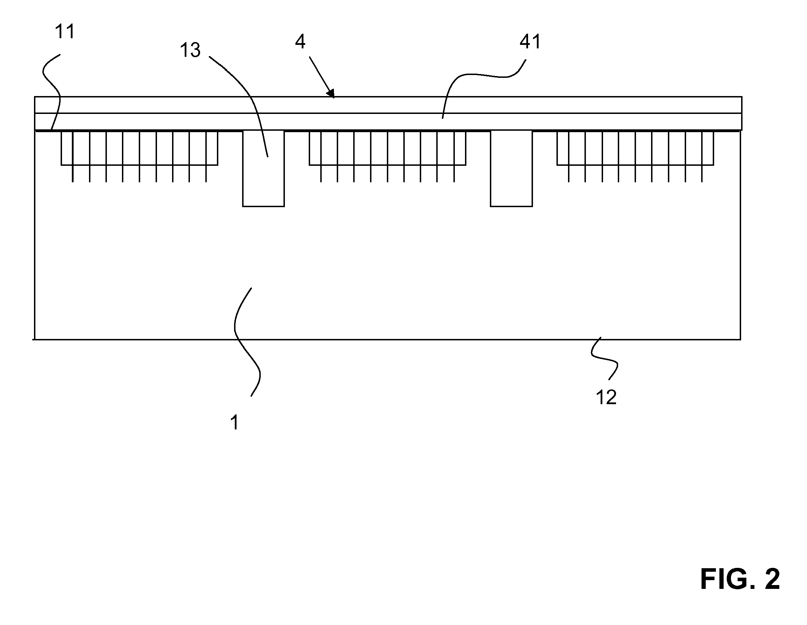

- Figure 2: shows a wafer with back grinding tape;
- Figure 3: shows a wafer after grinding;
- Figure 4: shows a wafer during de-taping;
- Figure 5: shows a wafer with a singulation tape;
- Figure 6: shows a wafer on an etching chuck;
- Figure 7: shows singulated dies;
- Figure 8: shows singulated dies after treatment; and
- Figure 9: shows picking of singulated dies.

The starting point of the example shown in the enclosed figures is a thick wafer, which has been fully processed, i.e. where active elements have been provided.

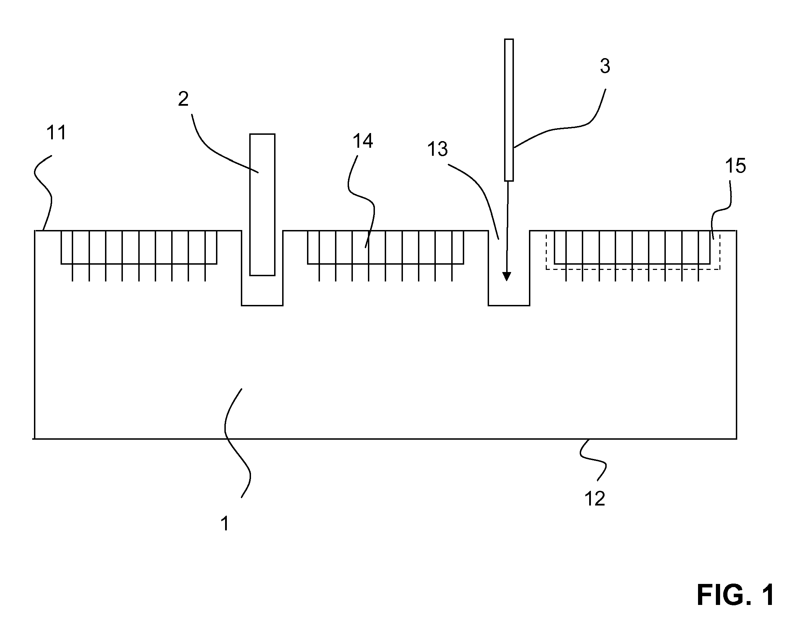

In a first step shown in Figure 1 the wafer 1 is partially diced from the front or active side 11 of the wafer 1 via a dicing blade 2 or by means of laser 3. The depth of the street or trench 13 is for example 50µm or 75µm. The kerf width is small and the dicing can be performed at high speed. In particular when a laser 3 is used to form the trench 13 in the active side 11 of the wafer 1, the amount of front side chipping, i.e. chipping of wafer material from the active side 11 is minimal. As the trenches 13 are only formed from the front or active side 11 no back side chipping, i.e. chipping of wafer material from the backside 12 will occur. The dashed line in Figure 1 indicates the intended final die 15 of the present example.

Only after the wafer 1 has been pre-diced, a back grinding tape 4 will be mounted on the backside 12 of the wafer 1. The back grinding tape 4 can be any back grinding tape. There are in particular no special requirements for the thickness of the glue layer 41 of the back grinding tape 4. A rather thin glue layer 41 is sufficient. Normal back grinding taper can be used to apply the back grinding tape 4 to the active side 11 of the wafer 1. In case the trenches 13 are introduced via a laser 3, the trenches can extend to the edge of the wafer 1. It is, however, also possible that the trenches 13 terminate at a distance from the edge of the wafer 1, i.e. the edge of the wafer 1 will be excluded from the pre-dicing. Thereby the streets or trenches 13 are completely sealed once the back grinding tape 4 is applied to the active side 11 of the wafer and for example water penetration can be minimized. If the trenches 13 are inserted via dicing blades 2, the trenches or streets 13 will be sealed via glue. The glue may be applied in addition to the glue present in the glue layer 41 of the back grinding tape 4 on the edges of the wafer 1.

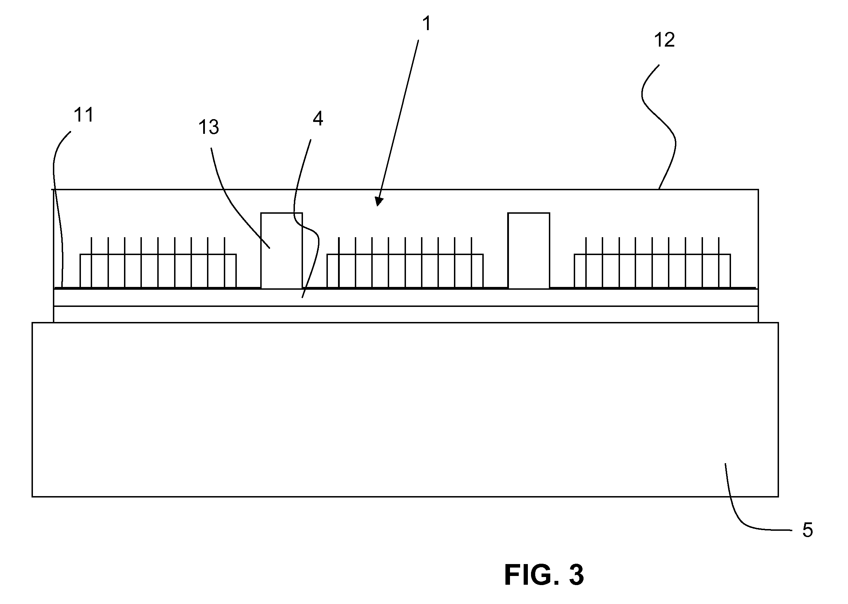

In a third step the wafer 1 will be turned over so that the active side 11 with the back grinding tape 4 attached to it will be facing down. The wafer 1 will then be positioned on a grinding chuck 5, where it will be held in position during the subsequent grinding process. The positioning of the wafer 1 is shown in Figure 3. The backside 12 of the wafer 1 will then be ground down by known grinding methods. Preferably, the thickness of the wafer 1 after grinding is larger then the target thickness of the dies or chips 15 to be singulated. The wafer 1 may for example be ground down to about 10µm above the target thickness of the die or chip 15.

Subsequently the wafer 1 may be subjected at its backside 12 to a polishing step, for example a dry polishing step or a chemical mechanical polishing step. After the polishing the subsurface damage in the wafer material, which have been introduced during grinding is minimized. As the grinding of the backside 12 of the wafer 1 does not lead to singulation of the dies 15, water, other fluids or particles used or generated during the grinding and potential polishing steps cannot penetrate into the trenches or streets 13 in the active side 11 of the wafer 1. As the dies 15 are not singulated also no chip or die displacement can occur during the grinding and polishing of the backside 12 of the wafer 1. As the pressure on the wafer 1 is minimal, the dies 15 formed on the active side 11 of the wafer 1 will not be squeezed into the glue layer 41 of the back grinding tape 4. Hence, the complete chip or die15, i.e. also the sides of the chips or die 15 can be treated in subsequent processing steps. This is not possible with known Dicing before Grinding (DBG) processes as the glue of the back grinding tape will block the trenches and will thus cover the sides of the chips or dies.

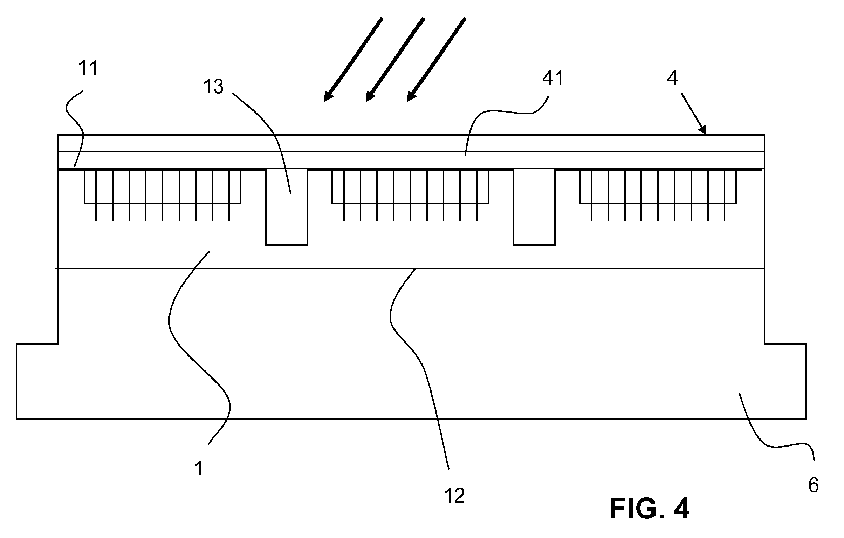

As shown in Figure 4, the thus prepared wafer 1 is rotated and placed with the backside 12 on a vacuum chuck, which will hereinafter be referred to as a mounter-peeler chuck 6. On this mounter-peeler chuck 6 the front or active side 11 of the wafer 1 carrying the back grinding tape 4 is exposed to UV-light. By this UV-illumination the back grinding tape 4 can be removed, in particular peeled off from the active side 11 of the wafer 1. As the wafer 1 has not been singulated into dies 15 at this point, the wafer 1 can be held on the mounter-peeler chuck 6 with safe suction.

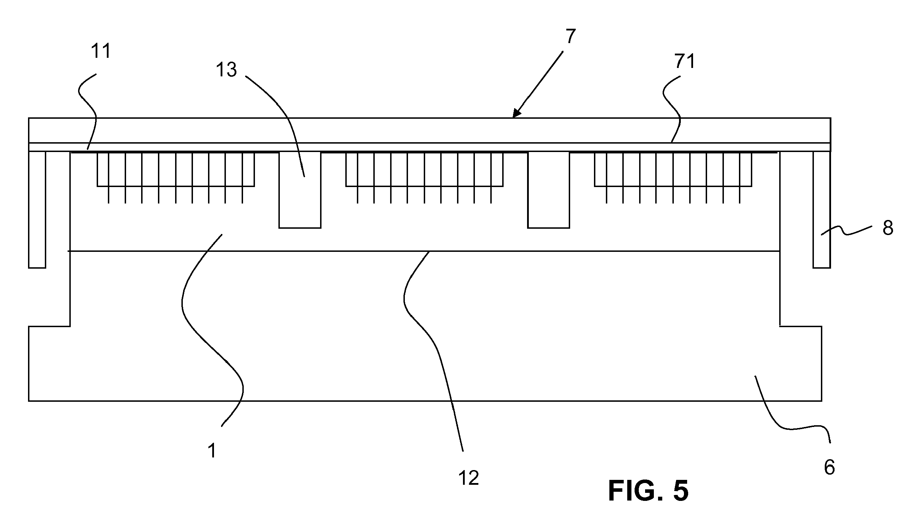

After the back grinding tape 4 has been removed, the wafer 1 without having been moved from the mounter-peeler chuck 6 will be provided with a singulation tape 7. This is shown in Figure 5. The singulation tape 7 which is held on a frame 8 will be placed on the active side 11 of the wafer 1 to protect the active elements thereof. As the singulation tape 7 with the frame 8 is applied on the same mounter-peeler chuck 6 no additional handling of the wafer 1 is necessary. In addition, the active side 11 of the wafer 1 is always protected; first by the back grinding tape 4 and then by the singulation tape 7. The singulation tape 7 does not have to be a UV- sensitive tape, as the only steps carried out with the singulation tape 7 on the wafer 1 are an etching step and the picking or removing the dies from the singulation tape 7.

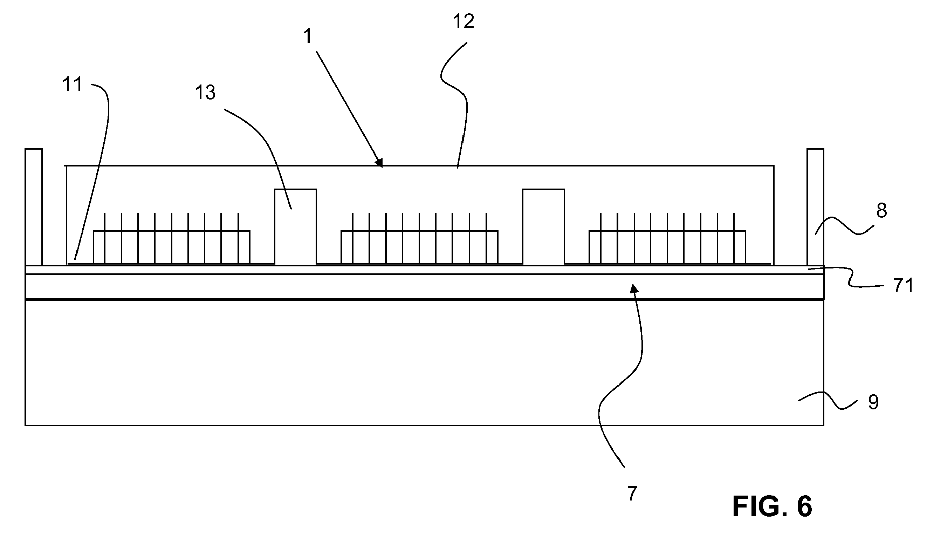

The thus supported pre-diced wafer 1 will be rotated and placed on an etching chuck 9, preferably a cooled chuck, as shown in Figure 6. The singulation tape 7 is facing the etching chuck 9. In this position, an etching step for etching the backside 12 of the wafer 1 is carried out. During this etching step the wafer 1 is thinned by e.g. 10µm. Due to the cutting depth of the initial diced streets or trenches 13 the dies 15 are singulated. At the same time the backside 12 of the wafer 1 is subjected to stress relief, i.e. stress induced into the wafer material by previous processing steps such as the grinding and polishing of the backside 12 are removed.

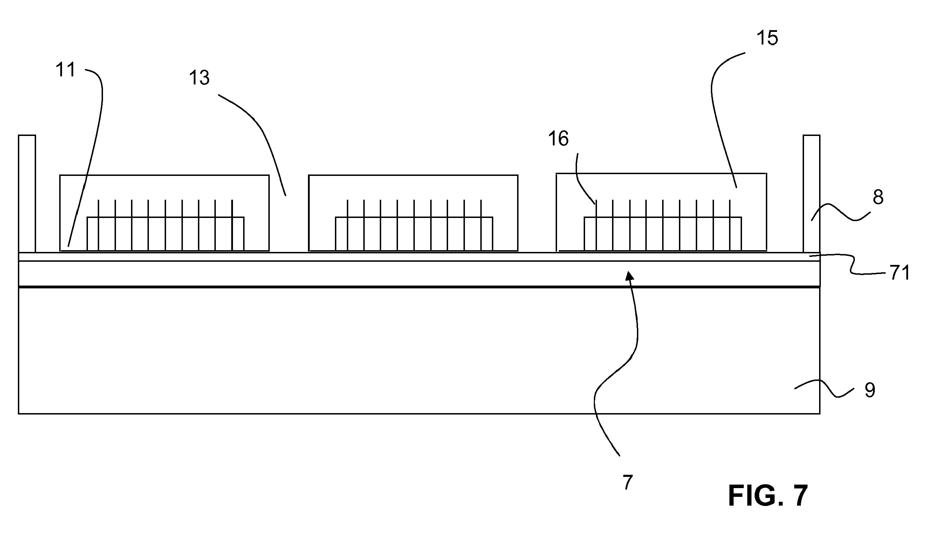

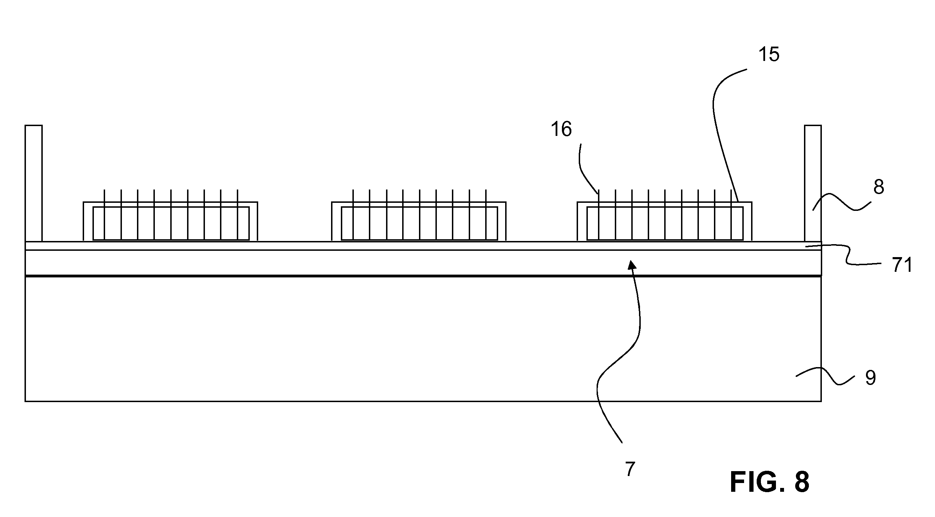

The singulated dies are shown in Figure 7. In this stage additional etching will lead to treatment of the side walls of the dies 15. The side walls of the dies 15 will be subjected to the stress relief treatment and in addition any edge chipping which might have occurred can be etched of. The process according to the present invention may be terminated at this stage. This means, the singulated dies 15 on the singulation tape 7 may be removed from the etching chuck 9 and may be picked and placed. In the example shown in the figures, the process, however, includes an additional step. As shown in Figure 8, the dies 15 are further etched after singulation, whereby the connections 16 which may be made of copper are exposed, i.e. extend over the wafer material of the die 15. This selective etching of the wafer material surrounding the connections 16 is possible due to the etching method wherein the etching is performed on radical basis.

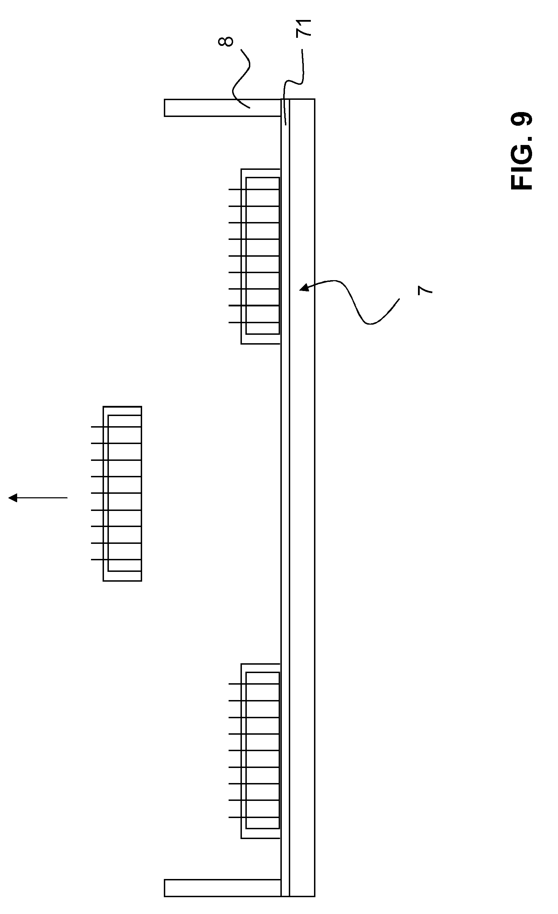

The thus singulated and further processed dies 15 can be picked and placed from the singulation tape 7 as shown in Figure 9.

### Reference List

- 1: wafer
- 11: active side
- 12: backside
- 13: street / trench
- 14: active element
- 15: die /chip
- 16: connection
- 2: dicing blade
- 3: Laser
- 4: Back grinding tape
- 41: glue layer
- 5: grinding chuck
- 6: mounter-peeler chuck
- 7: singulation tape
- 71: glue layer
- 8: frame
- 9: etching chuck

## Claims

1. Method for singulating wafers which comprises the steps of:
introducing trenches (13) between dies (15) to be separated in the active side (11) of a thick wafer (1);
applying a singulation tape (7) on the active side (11) of the wafer (1), wherein the singulation tape (7) is unsupported from the side facing away from the wafer (1) and
etching the backside (12) of the wafer (1) on the unsupported singulation tape (7) thereby at least separating the dies (15) on the wafer (1).

2. Method according to claim1, **characterized in that** the etching of the wafer (1) from the backside (12) is an etching step performed with a radical based dry etching method.

3. Method according to claim 1 or 2, **characterized in that** the etching method is a plasma etching method, in particular a remote plasma etching method.

4. Method according to anyone of claims 1 to 3, **characterized in that** the singulation tape (7) comprises a glue layer (71) with a thickness of less then 10µm, preferably less then 5µm.

5. Method according to anyone of claims 1 to 4, **characterized in that** the singulation tape (7) is attached to a frame (8).

6. Method according to anyone of claims 1 to 5, **characterized in that** the method comprises the step of grinding the wafer (1) from the backside (12) before the singulation by etching.

7. Method according to claim 6, **characterized in that** the singulation tape (7) is a tape different to a back grinding tape (4) used during a grinding step of grinding the backside (12) of the wafer (1).

8. Method according to claim 7, **characterized in that** removal of the back grinding tape (4) and the application of the singulation tape (7) are being performed on a single chuck (6).

9. Method according to anyone of claims 1 to 8, **characterized in that** the trenches (13) in the active side (11) of the wafer (1) are being introduced by means of a dicing blade (2) or by laser (3).

10. Method according to anyone of claims 1 to 9, **characterized in that** the trenches (13) which are provided in the active side (11) of the wafer (1) have a depth larger than the intended final height of the dies (15).
